# EUROPÄISCHE PATENTSCHRIFT

(11) **EP 1 020 106 B1**
(45) Veröffentlichungstag und Bekanntmachung des Hinweises auf die Patenterteilung: **16.01.2002**
(21) Anmeldenummer: 98958156.6
(22) Anmeldetag: 22.09.1998
(51) Int. Cl.: H05K 13/08

(54) **VERFAHREN UND VORRICHTUNG ZUR LAGEERKENNUNG VON ANSCHLÜSSEN UND/ODER KANTEN VON BAUELEMENTEN**
METHOD AND DEVICE FOR RECOGNIZING THE POSITION OF CONNECTIONS AND/OR EDGES OF COMPONENTS
PROCEDE ET DISPOSITIF POUR LA RECONNAISSANCE DE LA POSITION DE CONNEXIONS ET/OU DE BORDS DE COMPOSANTS

(30) Priorität: 30.09.1997 DE 19743352
(43) Veröffentlichungstag der Anmeldung: 19.07.2000
(73) Patentinhaber: Siemens Dematic AG, 90475 Nürnberg (DE)
(72) Erfinder: GRASMÜLLER, Hans-Horst, D-82291 Mammendorf (DE)
(74) Vertreter: Zedlitz, Peter, Dipl.-Inf.
(86) Internationale Anmeldenummer: DE9802823
(87) Internationale Veröffentlichungsnummer: WO9917599

(56) Entgegenhaltungen:
- EP-A- 0 320 317
- PATENT ABSTRACTS OF JAPAN vol. 135 (P-979), 20. Dezember 1989 & JP 01 241680 A (MATSUSHITA ELECTRIC IND CO LTD), 26. September 1989

## Beschreibung

Verfahren und Vorrichtung zur Lageerkennung von Anschlüssen und/oder Kanten von Bauelementen

Die Erfindung bezieht sich auf ein Verfahren und eine Vorrichtung zur Lageerkennung von Anschlüssen und/oder Kanten von Bauelementen gemäß dem Oberbegriff des Patentanspruchs 1 bzw. dem oberbegriff des Anspruchs 4. Ein solches Verfahren und eine solche Vorrichtung sind aus EP-A-0320317 bekannt.

Bei der automatischen Bestückung von Leiterplatten oder Keramiksubstraten mit SMD-Bauelementen werden die einzelnen Bauelemente mittels eines Bestückkopfes aus einem Magazin oder einer Zuführeinrichtung entnommen und dann in einer vorgegebenen Lage auf der Leiterplatte oder dem Keramiksubstrat positioniert. Da die Bauelemente im Magazin oder in der Abholposition einer Zuführeinrichtung eine Lagetoleranz von etwa 1 mm aufweisen, auf der Leiterplatte oder dem Keramiksubstrat aber mit hoher Genauigkeit positioniert werden müssen, ist eine automatische Lageerkennung und Korrektur erforderlich. Die Lageerkennung sollte möglichst wenig Zeit in Anspruch nehmen, um eine hohe Bestückleistung des Bestückautomaten zu ermöglichen.

Bekannte Anordnungen zur Lageerkennung der Anschlüsse und/oder der Kanten von Bauelementen bilden über ein Objektiv das Bauelement oder Ausschnitte des Bauelements auf eine flächenhafte CCD-Kamera ab und ermitteln über digitale Bildverarbeitung die Lage der Bauelementanschlüsse. Anschließend wird mithilfe einer Transportvorrichtung an der das Bauelement am Bestückkopf befestigt ist, die Lage des Bauelements vor dem Aufsetzen korrigiert. In der Praxis wird das Verfahren auch als optische Zentrierung der Bauelemente bezeichnet.

Aus WO 93/19577 ist ein Verfahren zur Lageerkennung bekannt, bei dem auf der lichtempfindlichen Fläche eines ortsauflösenden optoelektronischen Wandlers als Kamera ein unmittelbarer Schattenwurf des Anschlußbereichs einer Bauelementseite erzeugt wird. Der optoelektronische Wandler ist dabei am Bestückkopf befestigt und es wird die Lage der Anschlüsse in Bezug auf den optoelektronischen Wandler bestimmt. Durch eine bekannte relative Position des optoelektronischen Wandlers zum Bestückkopf wird daraus die Position der Anschlüsse in Bezug auf den Bestückkopf ermittelt. Bei diesem Verfahren wird vorausgesetzt, daß die Position der Kamera relativ zur Transportvorrichtung genau bekannt ist und genau angefahren werden kann. Jeglicher Fehler durch eine Drift des Kameraortes oder durch Einschwingvorgänge beim Anfahren der Kameraposition geht als Fehler in die Messung ein. Daher muß abgewartet werden, bis die Transportvorrichtung zur Ruhe gekommen ist.

Es sind auch Verfahren bekannt, bei denen während einer kontinuierlichen Bewegung der Transportvorrichtung mit dem Bauelement eine Aufnahme des Bauelements mit sehr kurzer Belichtungszeit (Blitzbetrieb) erfolgt. Zum Zeitpunkt der Aufnahme wird dann durch Übernahme eines Zählerstandes von Achsen der Transportvorrichtung die Position der Transportvorrichtung relativ zur Kamera bestimmt. Bei Schleppfehlern zwischen Zählerstand und aktueller Position der Transportvorrichtung wird auch bei diesem Verfahren die Bestimmung der relativen Position zwischen Bauelement und Transportvorrichtung erschwert.

Es ist daher die Aufgabe der Erfindung, ein Verfahren und eine Vorrichtung anzugeben, die eine genauere und schnellere Lageerkennung von Bauelementen in Bezug auf die Transportvorrichtung gewährleisten.

Die Aufgabe wird erfindungsgemäß mit einem Verfahren der eingangs genannten Art mit den kennzeichnenden Merkmalen gemäß Patentanspruch 1 gelöst.

Durch die gemeinsame Aufnahme von fest mit der Transportvorrichtung verbundenen Positionsmarkierungen und den Anschlüssen und/oder den Kanten der Bauelemente wird in der Bildauswerteeinheit die relative Position zwischen der Transportvorrichtung und den Anschlüssen und/oder den Kanten ohne Kenntnis der genauen Position der Kamera bestimmt, wodurch eine genauere Lageerkennung gewährleistet ist. Einschwingvorgänge haben keinen Einfluß auf die Genauigkeit, da sie auf die Positionsmarkierungen und den Anschluß und/oder die Kante in gleicher Weise wirken.

Dadurch, daß die Positionsmarkierungen so mit der Transportvorrichtung verbunden sind, daß sie in unmittelbarer Nähe der Anschlüsse und/oder der Kanten angeordnet sind, Können sie mit den Anschlüssen und/oder den Kanten in einem gemeinsamen Tiefenschärfebereich der Kamera liegen und gemeinsam scharf aufgenommen werden.

Die Positionsmarkierungen werden durch eine optische Abbildung in die unmittelbare Nähe der Anschlüsse und/oder der Kanten abgebildet, wodurch die Umgebung der Anschlüsse und/oder der Kanten von aufwendigen Konstruktionen freigehalten wird.

In Anspruch 2 wird das Verfahren in vorteilhafter Weise dadurch weitergebildet, daß die Abbildung auf eine Mattscheibe in unmittelbarer Nähe der Anschlüsse und/oder der Kanten erfolgt, wodurch sich die Aufnahme der Abbildung durch die Kamera vereinfacht.

Im Verfahren nach Anspruch 3 wird eine schnellerer Ablauf der Lageerkennung der Bauelemente dadurch sichergestellt, daß die Aufnahme mit kurzer Belichtungszeit und damit auch während der Bewegung der Transportvorrichtung erfolgt.

In Anspruch 4 ist eine Vorrichtung zur Durchführung des Verfahren angegeben, die in den abhängigen Ansprüchen weiter ausgebildet wird.

Die Vorrichtung überträgt die aktuelle Position der Transportvorrichtung durch die direkte Anordnung der Positionsmarkierungen in der unmittelbaren Nähe der Anschlüsse und/oder der Kanten besonders stabil auf die Aufnahme.

Die Vorrichtung weist den zusätzlichen Vorteil auf, daß durch die optische Abbildungsvorrichtung ein reelles Bild der Positionsmarkierung in der Nähe der Anschlüsse und/oder der Kanten erzeugt wird, womit aufwendige Befestigungskonstruktionen in unmittelbarer Nähe der Anschlüsse und/oder der Kanten vermieden werden.

In der vorteilhaften Ausgestaltung gemäß Anspruch 5 ist auch die optische Abbildungseinrichtung fest mit der Transportvorrichtung verbunden, damit die Position des reellen Bildes nicht von einer eventuell variierenden Position der optischen Abbildungseinrichtung abhängig ist.

In der Ausgestaltung nach Anspruch 6 ist zusätzlich eine Mattscheibe vorgesehen, auf die das reelle Bild projiziert wird, was die Aufnahme des reellen Bildes durch die Kamera erleichtert.

Nach Anspruch 7 ist auch die Mattscheibe zur Vermeidung zusätzlicher Unsicherheiten bei der Positionsbestimmung mit der Transportvorrichtung fest verbunden.

Die Mattscheibe läßt sich in vorteilhafter Weise auch mit der Kamera gemäß Anspruch 8 verbinden, wodurch die Transportvorrichtung leichter und damit einfacher beweglicher wird.

In einer vorteilhaften Ausgestaltung läßt sich die Mattscheibe als Teil einer Feldlinse gemäß Anspruch 9 ausgestalten, wodurch für das reelle Bild mehr Licht zur Verfügung steht.

Im folgenden wird die Erfindung anhand von Ausführungsbeispielen in den Figuren der Zeichnung näher erläutert.

Dabei zeigen
Figur 1 einen schematischen Querschnitt durch eine Vorrichtung zur Lageerkennung mit Positionsmarkierungen in unmittelbarer Nähe der Anschlüsse und
Figur 2 einen schematischen Querschnitt durch eine Vorrichtung zur Lageerkennung mit einer Abbildung der Positionsmarkierungen auf eine an der Transportvorrichtung befestigte Mattscheibe in unmittelbarer Nähe der Anschlüsse und
Figur 3 einen schematischen Querschnitt durch eine Vorrichtung zur Lageerkennung mit einer Abbildung der Positionsmarkierungen auf eine an der Kamera befestigte Mattscheibe.

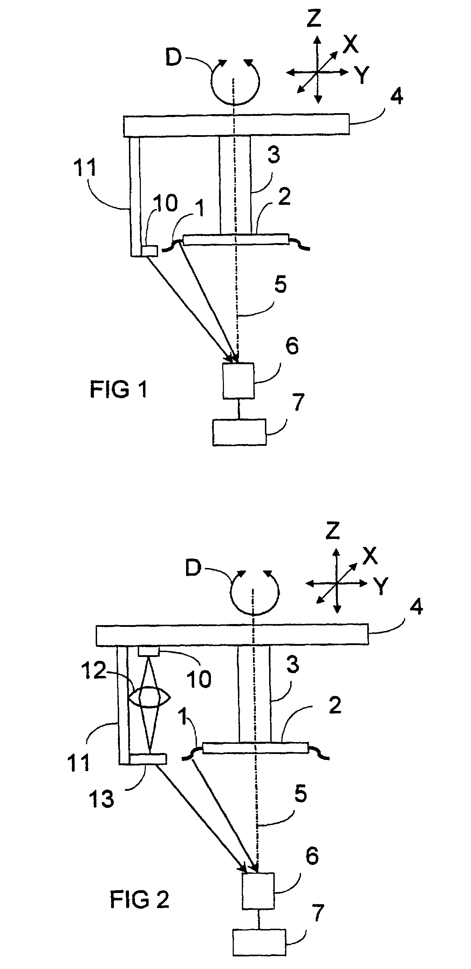

In Fig.1 ist dargestellt, wie die Anschlüsse 1 eines Bauelements 2 zur Lageerkennung verwendet werden. Analog zu den Anschlüssen 1 können auch die Kanten von den Bauelementen 2 zur Lageerkennung benutzt werden. Das Bauelement 2 wird dabei beispielsweise durch eine Saugpipette 3 an einer Transportvorrichtung 4 eines nicht dargestellten Bestückkopfes lösbar befestigt. Die Transportvorrichtung läßt sich zum Abholen des Bauelements 2 aus nicht dargestellten Zuführeinrichtungen und zum Aufsetzen des Bauelementes 2 auf nicht dargestellten Leiterplatten oder Keramiksubstraten in mindestens 3 Richtungen X,Y,Z translatorisch bewegen und zur Lagekorrektur des Bauelementes ist zusätzlich eine Drehbewegung D beispielsweise um eine Mittelachse 5 der Saugpipette 3 vorgesehen. Eine Kamera 6 mit nachgeschalteter Bildauswerteeinheit 7 für eine digitale Bildauswertung nimmt die Anschlüsse gemeinsam mit mindestens einer Positionsmarkierung 10 auf, die über eine Befestigungsvorrichtung 11 fest mit der Transportvorrichtung 4 verbunden ist. Dadurch ist die relative Position zwischen der Positionsmarkierung 10 und der Transportvorrichtung fest vorgegeben und bekannt. Die Positionsmarkierung 10 ist dabei so angeordnet, daß sie sich im gleichen Tiefenschärfebereich der Kamera 6 wie die Anschlüsse 1 befindet, damit die Positionsmarkierung und die Anschlüsse 1 gemeinsam scharf abgebildet werden. In der Bildauswerteeinheit 7 wird somit direkt die relative Position zwischen dem Bauelement 2 und der Transportvorrichtung 4 bestimmt und daraus eine Korrektur der Bewegung der Transportvorrichtung 4 zum Erreichen der korrekten Absetzposition des Bauelements 2 auf der Leiterplatte oder dem Keramiksubstrat ermittelt.

In Fig. 2 ist als zusätzliches Ausführungsbeispiel eine Vorrichtung dargestellt, in der die Positionsmarkierungen 10 gegenüber dem vorigen Ausführungsbeispiel weiter von den Anschlüssen 1 entfernt sind, aber über eine optische Abbildungseinrichtung 12 auf eine Mattscheibe 13 abgebildet werden. Die Mattscheibe 13 ist dabei in unmittelbarer Nähe der Anschlüsse 1 angeordnet, so daß sie sich mit den Anschlüssen 1 im gleichen Tiefenschärfebereich der Kamera 6 befindet. In vorteilhafter Weise sind die Mattscheibe 13 und die optische Abbildungseinrichtung 12 über die Befestigungsvorrichtung 11 mit der Transporteinrichtung 4 fest verbunden, damit keine Verschiebungen zwischen diesen Komponenten auftreten, die zu ungenaueren Positionsbestimmungen führen würden.

Auf die Mattscheibe 13 kann auch verzichtet werden, wenn das reelle Bild der Positionsmarkierung direkt mit der Kamera 6 aufgenommen wird. Dadurch werden komplizierte Konstruktionen in der Nähe des Bauelementes 2 und der Anschlüsse 1 vermieden, wodurch auch unterschiedlich große Bauelemente 2 mit einer gemeinsamen Lageerkennungseinrichtung bearbeitet werden können.

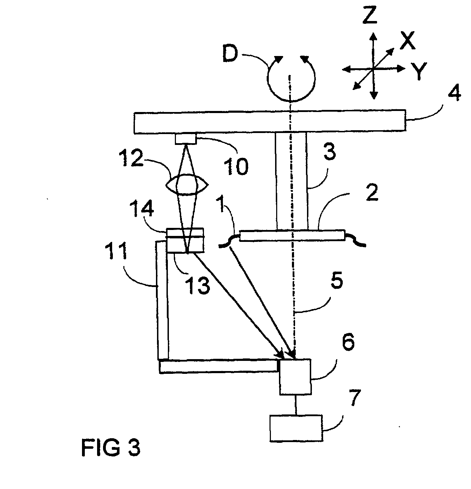

In Fig.3 ist dargestellt, daß die Mattscheibe 13 auch an der Kamera 6 befestigt sein kann. Die Mattscheibe 13 läßt sich vorteilhaft als Teil einer Feldlinse 14 ausbilden, wobei die Feldlinse. 14 zumindest einen Teil der optischen Abbildungseinrichtung 12 darstellt. Durch die Feldlinse 14 steht mehr Licht für das Erzeugen des Bildes zur Verfügung, das Bild wird lichtstärker.

Durch die direkte Aufnahme der Position der Transportvorrichtung 4 mit den Anschlüssen 1 des Bauelementes 2 läßt sich bei kurzer Belichtungszeit die relative Lage zwischen der Transportvorrichtung 4 und den Anschlüssen 1 auch bei gegenüber der Kamera 6 bewegter Transportvorrichtung 4 ermitteln, wodurch die Zeit für die Lageerkennung reduziert und die Bestückleistung erhöht wird.

## Patentansprüche

1. Verfahren zur Lageerkennung von Anschlüssen (1) und/oder Kanten von Bauelementen (2) in Bezug auf eine Transportvorrichtung (4), an der die Bauelemente (2) zum Transport lösbar befestigt sind, wobei in Lageerkennungseinrichtungen, die eine Kamera (6) mit nachgeschalteter Bildauswerteeinheit (7) umfassen, die Kamera (6) zumindest bereichsweise eine Abbildung der Anschlüsse (1) und/oder der Kanten aufnimmt und mindestens eine Positionsmarkierung (10) fest mit der Transportvorrichtung (4) verbunden wird, **dadurch gekennzeichnet,**
**daß** ein reelles Bild der Positionsmarkierung (10) in unmittelbarer Nähe der Anschlüsse (1) und/oder der Kanten erzeugt wird und
**daß** das reelle Bild gemeinsam mit den Anschlüssen (1) und/oder den Kanten von der Kamera (6) aufgenommen wird und daß aus der gemeinsamen Aufnahme der Positionsmarkierung (10) und der Anschlüsse (1) und/oder der Kanten die relative Position zwischen den Anschlüssen (1) und/oder den Kanten und der Positionsmarkierung (10) und damit zwischen den Anschlüssen (1) und/oder den Kanten und der Transportvorrichtung (4) bestimmt wird.

2. Verfahren zur Lageerkennung nach Anspruch 1,
**dadurch gekennzeichnet,**
**daß** das reelle Bild in der unmittelbaren Nähe der Anschlüsse (1) und/oder den Kanten auf eine Mattscheibe (13) projiziert wird.

3. Verfahren zur Lageerkennung nach einem der Ansprüche 1 oder 2,
**dadurch gekennzeichnet,**
**daß** eine gemeinsame Aufnahme der Anschlüsse (1) und/oder der Kanten und der Positionsmarkierung (10) mit einer kurzen Belichtungszeit während der Bewegung der Transportvorrichtung (4) erfolgt.

4. Vorrichtung zur Lageerkennung von Anschlüssen (1) und/oder Kanten von Bauelementen (2) in Bezug auf eine Transportvorrichtung (4), an der die Bauelemente (2) zum Transport lösbar befestigt sind, mit einer Kamera (6) mit nachgeschalteter Bildauswerteeinheit (7), wobei die Kamera (6) zumindest bereichsweise eine Abbildung der Anschlüsse (1) und/oder der Kanten aufnimmt und mindestens eine Positionsmarkierung (10) fest über eine Befestigungsvorrichtung (11) mit der Transportvorrichtung (4) verbunden ist,
**dadurch gekennzeichnet,**
**daß** eine optische Abbildungseinrichtung (12) so angeordnet ist, daß diese optische Abbildungseinrichtung (12) ein reelles Bild der Positionsmarkierung (10) in unmittelbarer Nähe der Anschlüsse (1) und/oder der Kanten erzeugt, so daß für die Kamera (6) die Abbildung der Anschlüsse (1) und/oder Kanten gemeinsam mit dem reellen Bild aufnehmbar ist.

5. Vorrichtung zur Lageerkennung nach Anspruch 4,
**dadurch gekennzeichnet,**
**daß** die optische Abbildungseinrichtung (12) fest mit der Transportvorrichtung (4) verbunden ist.

6. Vorrichtung zur Lageerkennung nach einem der Ansprüche 4 oder 5,
**gekennzeichnet durch**
eine in unmittelbarer Nähe der Anschlüsse (1) und/oder der Kanten angeordnete Mattscheibe (13), auf die das reelle Bild projiziert wird.

7. Vorrichtung zur Lageerkennung nach Anspruch 6,
**dadurch gekennzeichnet,**
**daß** die Mattscheibe (13) fest mit der Transportvorrichtung (4) verbunden ist.

8. Vorrichtung zur Lageerkennung nach Anspruch 6,
**dadurch gekennzeichnet,**
**daß** die Mattscheibe (13) fest mit der Kamera (6) verbunden ist.

9. Vorrichtung nach zur Lageerkennung nach einem der Ansprüche 6 bis 8,
**dadurch gekennzeichnet,**
**daß** die Mattscheibe (13) als Teil einer Feldlinse (14) ausgebildet ist.

## Claims

1. Method for identifying the position of connections (1) and/or edges of components (2) with regard to a conveying apparatus (4), on which the components (2) are fastened, for transport, in a manner that allows them to be released, in which case, in position identification devices comprising a camera (6) with an image evaluation unit (7) connected downstream, the camera (6) records an imaging of the connections (1) and/or of the edges at least in regions, and at least one position marking (10) is fixedly connected to the conveying apparatus (4),
**characterized**
**in that** a real image of the position marking (10) is generated in direct proximity to the connections (1) and/or the edges, and
**in that** the real image is recorded together with the connections (1) and/or the edges by the camera (6), and in that the relative position between the connections (1) and/or the edges and the position marking (10) and hence between the connections (1) and/or the edges and the conveying apparatus (4) is determined from the common recording of the position marking (10) and the connections (1) and/or the edges.

2. Method for position identification according to Claim 1,
**characterized**
**in that** the real image in direct proximity to the connections (1) and/or the edges is projected onto a matt plate (13).

3. Method for position identification according to either of Claims 1 and 2,
**characterized**
**in that** the connections (1) and/or the edges and the position marking (10) are recorded jointly with a short exposure time during the movement of the conveying apparatus (4).

4. Apparatus for identifying the position of connections (1) and/or edges of components (2) with regard to a conveying apparatus (4) on which the components (2) are fastened, for transport, in a manner that allows them to be released, having a camera (6) with an image evaluation unit (7) connected downstream, in which case the camera (6) records an imaging of the connections (1) and/or the edges at least in regions, and at least one position marking (10) is fixedly connected to the conveying apparatus (4) by means of a fastening apparatus (11),
**characterized**
**in that** an optical imaging device (12) is arranged in such a way that the said optical imaging device (12) generates a real image of the position marking (10) in direct proximity to the connections (1) and/or the edges, with the result that, for the camera (6), the imaging of the connections (1) and/or edges can be recorded jointly with the real image.

5. Apparatus for position identification according to Claim 4,
**characterized**
**in that** the optical imaging device (12) is fixedly connected to the conveying apparatus (4).

6. Apparatus for position identification according to either of Claims 4 and 5,
**characterized by**
a matt plate (13) arranged in direct proximity to the connections (1) and/or the edges, the real image being projected onto the said matt plate.

7. Apparatus for position identification according. to Claim 6,
**characterized**
**in that** the matt plate (13) is fixedly connected to the conveying apparatus (4).

8. Apparatus for position identification according to Claim 6,
**characterized**
**in that** the matt plate (13) is fixedly connected to the camera (6).

9. Apparatus for position identification according to one of Claims 6 to 8,
**characterized**
**in that** the matt plate (13) is designed as part of a field lens (14).

## Revendications

1. Procédé de reconnaissance de la position de bomes (1) et/ou de bords de composants (2) par rapport à une installation (4) de transport sur laquelle les composants (2) sont fixés de manière amovible pour le transport, une reproduction des bornes (1) et/ou des bords au moins région par région étant enregistrée dans des dispositifs de reconnaissance de position, qui comprennent un appareil (6) photographique ayant une unité (7) d'exploitation de l'image en aval, l'appareil (6) photographique enregistrant au moins par endroits une reproduction des bornes (1) et/ou des bords et au moins un repère (10) de position étant solidaire de l'installation (4) de transport,
**caractérisé**
**en ce qu'**il consiste à produire une image réelle du repère (10) de position à proximité immédiate des bornes (1) et/ou des bords et
à enregistrer l'image réelle conjointement avec les bornes (1) et/ou les bords par l'appareil (6) photographique et à déterminer à partir de l'enregistrement conjoint du repère (10) de position et des bornes (1) et/ou des bords la position relative entre les bornes (1) et/ou les bords et le repère (10) de position et ainsi entre les bornes (1) et/ou les bords et l'installation (4) de transport.

2. Procédé de reconnaissance de position suivant la revendication 1,
**caractérisé**
**en ce qu'**il consiste à projeter l'image réelle à proximité immédiate des bornes (1) et/ou des bords sur un verre dépoli (13).

3. Procédé de reconnaissance de position suivant l'une des revendications 1 ou 2,
**caractérisé**
**en ce qu'**il consiste à effectuer un enregistrement conjoint des bomes (1) et/ou des bords et du repère (10) de position avec une durée courte d'exposition pendant le déplacement de l'installation (4) de transport.

4. installation de reconnaissance de position de bornes (1) et/ou de bords de composants (2) par rapport à une installation (4) de transport sur laquelle les composants (2) sont fixés de manière amovible pour le transport, comprenant un appareil (6) photographique ayant une unité (7) d'exploitation de l'image en aval, l'appareil photographique enregistrant au moins par endroits une reproduction des bornes (1) et/ou des bords et au moins un repère (10) de position étant rendu solidaire de l'installation (4) de transport par un dispositif (11) de fixation,
**caractérisée**
**en ce qu'**un dispositif (12) optique de reproduction est disposé de manière que ce dispositif (12) optique de reproduction produise une image réelle du repère (10) de position à proximité immédiate des bornes (1) et/ou des bords, de sorte que la reproduction des bornes (1) et/ou de bords puisse être enregistrée par l'appareil (6) photographique conjointement avec l'image réelle.

5. Installation de reconnaissance de position suivant la revendication 4,
**caractérisée**
**en ce que** le dispositif (12) optique de reproduction est solidaire de l'installation (4) de transport.

6. Installation de reconnaissance de position suivant l'une des revendications 4 ou 5,
**caractérisée par**
un verre dépoli (13) qui est disposé à proximité immédiate des bornes (1) et/ou des bords et sur lequel est projetée l'image réelle.

7. Installation de reconnaissance de position suivant la revendication 6,
**caractérisée**
**en ce que** le verre dépoli (13) est solidaire de l'installation (4) de transport.

8. Installation de reconnaissance de position suivant la revendication 6,
**caractérisée**
**en ce que** le verre dépoli (13) est solidaire de l'appareil (6) photographique.

9. Installation de reconnaissance de position suivant l'une des revendications 6 à 8,
**caractérisée**
**en ce que** le verre dépoli (13) est constitué en tant que partie d'une lentille (14) de champ.
